# FASCICULE DE BREVET EUROPEEN

(11) **EP 2 888 761 B1**
(45) Date de publication et mention de la délivrance du brevet: **08.05.2019**
(21) Numéro de dépôt: 13756637.8
(22) Date de dépôt: 31.07.2013
(51) Int. Cl.: H01L 21/60, H01L 21/48, H01L 23/498, H01L 23/485, H01L 23/14, H01L 21/56

(54) **HYBRIDATION FACE CONTRE FACE DE DEUX COMPOSANTS MICROELECTRONIQUES A L'AIDE D'UN RECUIT UV**
FLIP-CHIP-VERBINDUNG VON ZWEI MIKROELEKTRONISCHEN BAUTEILEN MITTELS UV-GLÜHEN
FLIP-CHIP CONNECTION OF TWO MICROELECTRONIC COMPONENTS USING A UV ANNEAL

(30) Priorité: 21.08.2012 FR 1257897
(43) Date de publication de la demande: 01.07.2015
(73) Titulaire: Commissariat à l'Énergie Atomique et aux Énergies Alternatives, 75015 Paris (FR)
(72) Inventeur: ALIANE, Abdelkader, F-38100 Grenoble (FR); COPPARD, Romain, F-38500 Voiron (FR); TALLAL, Jamal, F-38100 Grenoble (FR)
(74) Mandataire: Cabinet Laurent & Charras
(86) Numéro de dépôt international: PCT/FR2013/051852
(87) Numéro de publication internationale: WO 2014/029930

(56) Documents cités:
- WO-A1-2012/060262
- JP-A- 2006 269 119
- JP-A- 2008 208 442
- US-A- 5 829 125
- US-A1- 2004 150 967
- US-A1- 2009 127 704

## Description

### DOMAINE DE L'INVENTION

L'invention a trait au domaine de l'hybridation face contre face de deux composants microélectroniques, ou hybridation « *flip chip ».*

### ETAT DE LA TECHNIQUE

L'hybridation face contre face est une technique consistant à réaliser de manière indépendante deux composants microélectroniques, par exemple une matrice d'éléments photosensibles et un circuit de lecture de celle-ci, et de reporter l'un sur l'autre ces composants tout en réalisant des interconnexions électriques entre ceux-ci, nécessaires à leur fonctionnement.

Selon l'état de la technique, les interconnexions sont réalisées sous la forme de billes de soudure disposées entre des plages métalliques mouillables par le matériau constitutif des billes formées sur des faces en regard des composants. Le procédé d'hybridation consiste alors à réaliser lesdites plages sur les faces des composants à hybrider, à déposer un matériau de soudure sur les plages d'un premier composant, à reporter le second composant sur le premier composant en alignant les plages des deux composants, puis à chauffer l'ensemble à une température faisant fondre le matériau de soudure afin de réaliser les interconnexions électriques.

Ce type d'hybridation présente cependant le désavantage de soumettre les composants à un choc thermique important, la température de fusion des matériaux des billes étant usuellement supérieure à 152°C, cette température étant la température de fusion du matériau de soudure, à savoir l'étain. Ce chauffage peut ainsi fragiliser les composants et/ou interdire l'utilisation de matériau ne supportant pas de telles températures, comme les plastiques, notamment le PEN (polyéthylène naphtalate) et le PET (polyéthylène téréphtalate), dont la température de transition vitreuse est usuellement très inférieure à la température de fusion des matériaux de soudure.

### EXPOSE DE L'INVENTION

Le but de l'invention est de proposer un procédé de fabrication d'un dispositif comportant un premier et un second composants hybridés à l'aide d'interconnexions électriques, qui ne nécessite pas de porter l'ensemble du dispositif à une température élevée pour former lesdites interconnexions.

A cet effet, l'invention a pour objet un procédé selon la revendication 1, c'est-à-dire un procédé de fabrication d'un dispositif micro électronique comportant un premier composant hybridé à un second composant au moyen d'interconnexions électriques, comportant :
▪ la réalisation des premier et second composants, le second composant étant transparent à un rayonnement ultraviolet au moins au droit d'emplacements prévus pour les interconnexions ;
▪ la formation d'éléments d'interconnexion comprenant des plots constitués uniquement d'oxyde de cuivre sur le second composant aux emplacements prévus pour les interconnexions ;
▪ le report des premier et second composant l'un sur l'autre ; et
▪ l'application du rayonnement ultraviolet au travers du second composant sur les éléments comprenant de l'oxyde de cuivre de manière à mettre en oeuvre un recuit ultraviolet transformant l'oxyde de cuivre en cuivre.

Par « transparent », on entend ici un matériau qui laisse passer suffisamment de rayonnement ultraviolet pour permettre un recuit de l'oxyde de cuivre.

En d'autres termes, la réduction de l'oxyde de cuivre en cuivre par un recuit UV ne nécessite aucun chauffage global du dispositif. En outre, l'application du recuit UV n'induit pas, au niveau des interconnexions électriques, d'élévation importante de la température, et permet donc l'utilisation de matériaux tels que les plastiques pour la fabrication des composants.

Selon un mode de réalisation, la réalisation des éléments d'interconnexion comprend pour chacun de ceux-ci :
▪ la formation d'une plage sur le second composant, la plage comprenant une première région au moins partiellement transparente au rayonnement ultraviolet entourée d'une seconde région de moindre transparence que la première région ;
▪ et le dépôt d'oxyde cuivre sur ladite plage au moins sur la première région de celle-ci.

Notamment, la seconde région est réalisée en un matériau absorbant le rayonnement ultraviolet ou en un matériau réfléchissant le rayonnement ultraviolet, avantageusement une seconde région constituée d'or, de titane ou d'argent, d'une épaisseur supérieure à 30 nanomètres.

En d'autres termes, il est possible de contrôler la portion d'oxyde de cuivre qui subit la réduction en cuivre en la délimitant par une région qui absorbe ou réfléchit le rayonnement ultraviolet. Il est ainsi possible de réaliser des interconnexions limitées spatialement dans l'espace avec précision, même dans le cas d'utilisation d'une encre d'oxyde de cuivre qui s'étale une fois déposée.

Selon un mode de réalisation, le second composant est constitué de PEN, de PET ou de verre, qui sont des matériaux transparents aux UV et à bas coût. En outre, le PEN et le PET ont l'avantage d'être des matériaux flexibles.

Selon un mode de réalisation, la formation des interconnexions comporte la réalisation d'une couche d'oxyde métallique transparent, notamment d'ITO (Indium tin oxide), d'ATO (Antimony tin oxide) ou un autre oxyde métallique conducteur électriquement et transparent aux UV, sur le second composant. Ces oxydes métalliques conducteurs électriques laissent passer les UV, et sont utilisés comme pads de connexion électrique avec le cuivre après la transformation du CuO.

Selon un mode de réalisation, le recuit ultraviolet consiste en une impulsion photonique d'une durée comprise entre 0,5 milliseconde et 2 millisecondes et de fluence comprise entre 200 Joules et 1500 Joules, notamment une durée de 1,5 milliseconde et une fluence de 1400 Joules.

De telles valeurs permettent ainsi de transformer le CuO en Cu par la face arrière du substrat flexible d'une épaisseur par exemple de 125µm. Dans ce cas on parle d'énergie appliquée. On peut citer un ordre de grandeur pour la fluence qui est de 5,8J/cm² à 2 inch (5 cm) de la lampe Xenon.

### BREVE DESCRIPTION DES FIGURES

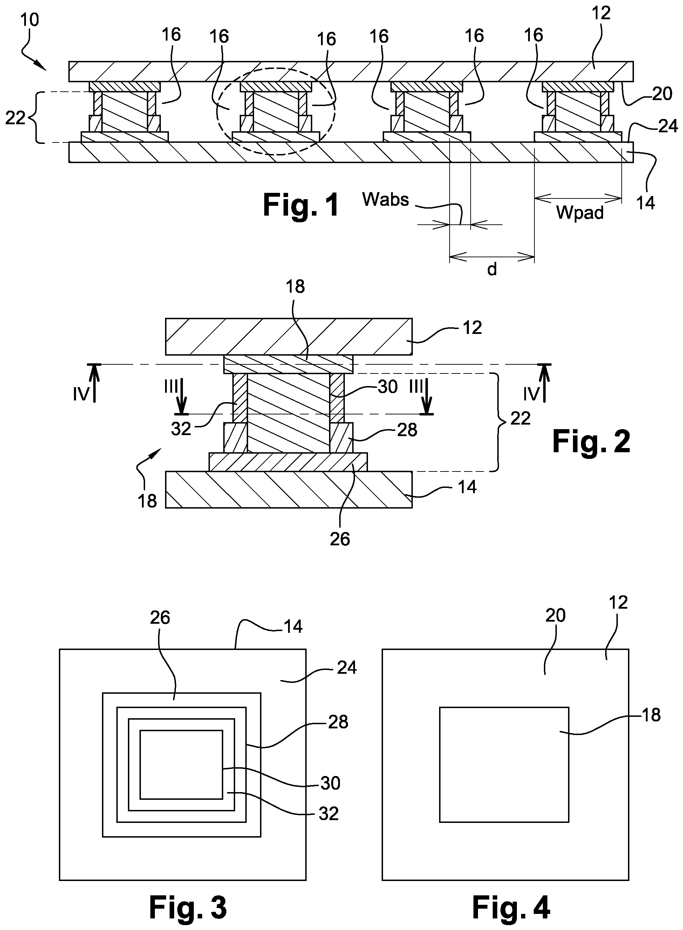

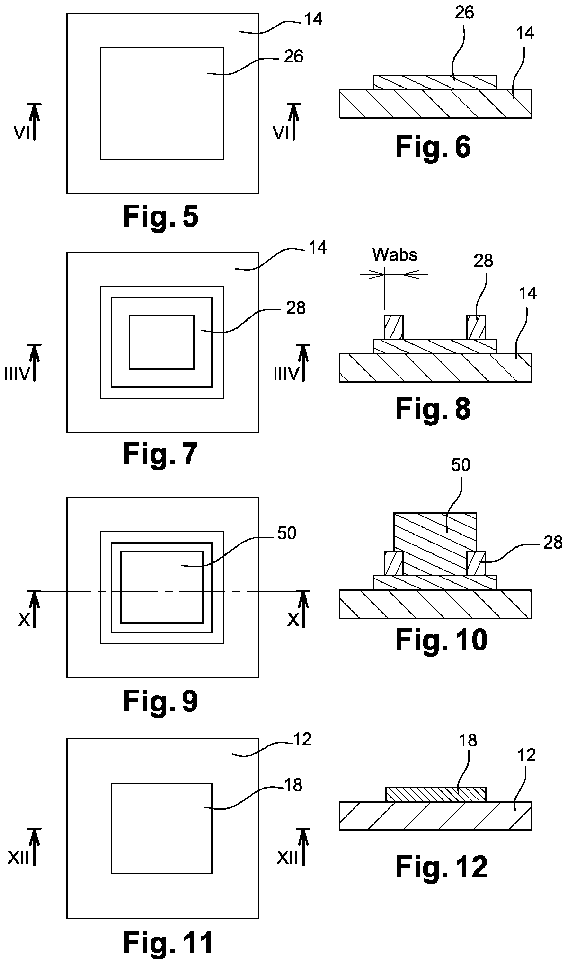

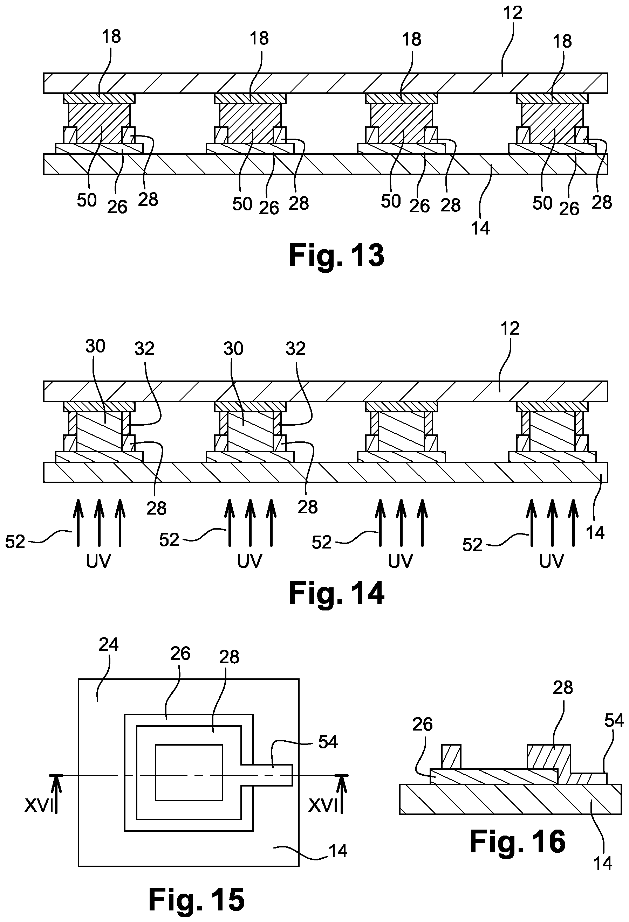

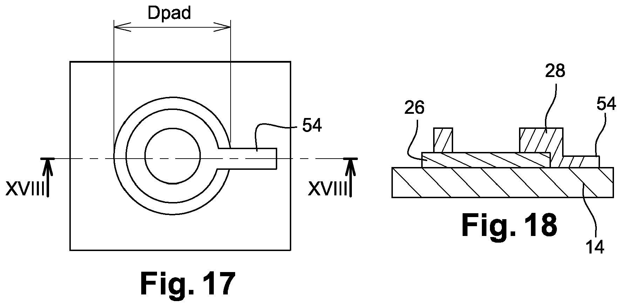

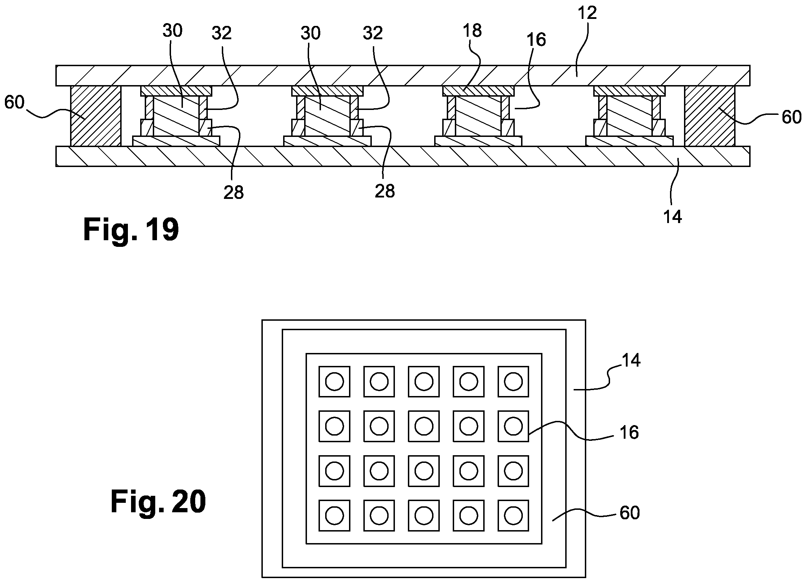

L'invention sera mieux comprise à la lecture de la description qui suit, donnée uniquement à titre d'exemple, et réalisée en relation avec les dessins annexés, dans lesquels des références identiques désignent des éléments identiques ou analogues, et dans lesquels:
▪ la figure 1 est une figure schématique en coupe d'un dispositif conforme au procédé selon l'invention ;
▪ la figure 2 est une vue de détail de la figure 1, illustrant une interconnexion conforme au procédé selon l'invention ;
▪ les figures 3 et 4 sont respectivement des vues schématiques en coupe selon le plan III-III et IV-IV de la figure 2 ;
▪ les figures 5 à 14 sont des vues schématiques de dessus et en coupe illustrant un procédé de fabrication du dispositif de la figure 1 ;
▪ les figures 15 et 16 sont des vues schématiques de dessus et en coupe d'une variante d'une interconnexion selon l'invention ;
▪ les figures 17 et 18 sont des vues schématiques de dessus et en coupe d'une variante d'une interconnexion selon l'invention ;
▪ la figure 19 est une vue schématique en coupe d'un dispositif conforme à l'invention avec de l'encre non conductrice électriquement dispensée entre les deux composants hybridés ;
▪ la figure 20 est une vue de dessus de l'un des composants illustrant la forme de l'encre.

### DESCRIPTION DETAILLEE DE L'INVENTION

Il va à être décrit en relation avec les figures 1 à 4 un dispositif **10** conforme au procédé selon l'invention. Le dispositif **10** comporte un premier et un second composants **12, 14** hybridés l'un à l'autre à l'aide d'interconnexions électriques **16.** Le premier composant **12** comprend par exemple une matrice d'éléments photosensibles, et le second composant comprend par exemple un circuit de lecture de ladite matrice, les interconnexions **16** connectant chaque élément photosensible de la matrice au circuit de lecture. Le second composant est en outre transparent au rayonnement ultraviolet au moins au droit des interconnexions **16.** Notamment, le second composant peut être essentiellement formé de plastiques flexibles, bas coût et transparents, tels que du PEN ou du PET ou encore être formé de verre, auquel cas le second composant est transparent sur l'ensemble de sa surface.

Les interconnexions **16** comprennent chacune une plage conductrice pleine **18** formée sur une face **20** du premier composant **12,** par exemple une plage métallique en or, en argent, en cuivre, en platine, en titane ou autres, et un élément d'interconnexion **22** formé sur une face **24** du second composant **14.**

Plus particulièrement, l'élément d'interconnexion **22** comporte :
▪ une plage pleine, conductrice et transparente au rayonnement ultraviolet **26,** formée sur la face **24** du composant **14,** avantageusement une plage constituée d'un oxyde métallique conducteur, tel que de l'ITO (oxyde d'indium dopé à l'étain) ou de l' ATO (Antimony tin oxide) ou un autre oxyde métallique conducteur et transparent aux UV, un tel oxyde présentant en outre l'avantage d'avoir une bonne accroche avec les plastiques et une bonne conductivité électrique ;
▪ une couronne **28** de matériau absorbant le rayonnement ultraviolet, formée sur la plage conductrice et transparente **26,** par exemple une couche d'or, de titane ou d'argent;
▪ un plot **30** de cuivre (Cu) formé dans la couronne **28,** et au contact de la plage conductrice **18** du premier composant **12** et de la plate conductrice **26** du second composant **14** ;
▪ une couronne **32** d'oxyde de cuivre (CuO), entourant le plot de cuivre **30** et agencée entre la couronne de matériau absorbant **28** et le premier composant **12.**

Chaque interconnexion **16** comporte ainsi un chemin conducteur de l'électricité entre les premier et second composants **12, 14,** formé des plages conductrices **18, 26** et du plot en cuivre **30.**

Il va à présent être décrit, en relation avec les figures 5 à 14, un procédé de fabrication du dispositif **10** venant d'être décrit, et plus particulièrement un procédé ne nécessitant pas l'emploi de température élevée pour former les interconnexions électriques **16.** A l'exception d'éventuelle étapes de recuit thermique optionnelles décrites ci-après, le procédé est avantageusement réalisé à température ambiante, aucun chauffage n'étant mis en oeuvre pour la réalisation des interconnexions **16** entre les deux composants **14, 16.**

Le procédé débute par la réalisation du composant **14,** transparent au moins au droit des emplacements prévus pour les interconnexions **16,** par exemple un composant flexible et bas coût, tel qu'un plastique PEN ou PET, ou un composant **14** en verre.

Le procédé se poursuit alors par la réalisation des éléments d'interconnexion **22.** Plus particulièrement, pour chacun de ceux-ci, une plage **26** pleine, carrée, conductrice et transparente au rayonnement ultraviolet est réalisée sur la face **24** du composant **14,** par exemple au moyen d'un dépôt pleine plaque par évaporation d'une couche d'oxyde transparent conducteur, tel que de l'ITO, suivi d'une gravure par voie humide ou par plasma afin de définir la plage **26** (figure 5 en vue de dessus et figure 6 en coupe selon le plan VI-VI de la figure 5).

Lors d'une étape suivante, une couronne **28,** de section carrée ou circulaire et réalisée en matériau absorbant le rayonnement ultraviolet, est déposée sur la plage **26** tout en laissant libre cette dernière dans le fond de la couronne **28.** Par exemple, la couronne **28** est constituée d'or, de platine ou d'argent, et est réalisée au moyen d'un dépôt pleine plaque par évaporation suivie d'une gravure par voie humide ou par plasma (figure 7 en vue de dessus et figure 8 en coupe selon le plan VIII-VIII de la figure 7).

L'épaisseur de la couronne **28** est choisie de manière à suffisamment bloquer le rayonnement ultraviolet incident sur la couronne **28** au travers du composant **14,** afin d'éviter un recuit ultraviolet d'un oxyde de cuivre déposé ultérieurement sur la couronne **28.** De manière avantageuse, lorsque la couronne **28** est constituée d'or, d'argent ou de titane, l'épaisseur de la couronne **28** est supérieure ou égale à 30 nanomètres. Optionnellement, des molécules à fort pouvoir absorbant dans l'ultraviolet sont mélangées au métal de la couronne **28** ou déposées directement sur le substrat flexible sous forme de couronne si les techniques de dépôt sont maitrisées, par exemple des molécules de pyrène, ce qui permet par exemple de diminuer l'épaisseur de la couronne **28.**

Le procédé se poursuit par le dépôt d'un oxyde de cuivre **50** dans la couronne **28,** notamment le dépôt par sérigraphie d'une encre d'oxyde de cuivre, par exemple l'encre de référence « Metalon® ICI-020 » ou « Metalon® ICI-021 » de la société Novacentrix, Texas, USA, de manière à faire dépasser l'oxyde de cuivre de la couronne **28.**

S'agissant d'une encre, cette dernière s'étale alors sur le bord de la couronne **28,** l'épaisseur *W_{abs}* de la couronne **28** étant avantageusement choisie pour offrir suffisamment de surface à l'étalement de l'encre et empêcher cette dernière de déborder par-dessus la couronne **28** (figure 9 en vue de dessus et figure 10 en coupe selon le plan X-X de la figure 11).

L'encre d'oxyde de cuivre **50** est ensuite séchée par un recuit thermique de manière à former des plots d'oxyde de cuivre.

Indépendamment de la fabrication du composant **14** et des éléments **26, 28, 50** venant d'être décrits, le procédé comprend la réalisation du premier composant **14** et de plages conductrices pleines et de section carrée **18,** par exemple au moyen d'un dépôt pleine plaque par évaporation d'une couche d'or, de titane, de platine, de cuivre ou d'argent sur la face **20** du composant **12,** suivi d'une gravure par voie humide ou par plasma afin de définir chaque plage **18** (figure 11 en vue de dessus et figure 12 en coupe selon le plan XII-XII de la figure 11).

Une fois les composants **12** et **14** et leurs éléments d'interconnexion réalisés comme décrit précédemment, le premier composant **12** est reporté sur le second composant **14** en alignant les plages **18** sur les plots d'oxyde de cuivre **50** (figure en coupe 13).

Le procédé se poursuit alors par l'application d'une impulsion photonique dans la gamme de longueurs d'onde ultraviolettes **52,** notamment de longueur d'onde comprise entre 200 nanomètres et 700 nanomètres, au travers du second composant **14** au moins au droit de chaque interconnexion **16,** l'impulsion étant par exemple appliquée sur l'ensemble de la surface du second composant **14** (figure 14). L'impulsion ultraviolette **52** a une durée comprise entre 0,5 milliseconde et 2 millisecondes, et une énergie comprise entre 200 Joules et 1400 Joules, de manière avantageuse une durée de 1,5 milliseconde et une énergie de 1400 Joules. Ces valeurs d'énergie permettent de transformer le CuO en Cu par la face arrière du substrat plastique de PEN ou PET de 125µm d'épaisseur. L'impulsion **52** est par exemple produite par une lampe flash UV, notamment une lampe flash de référence « XENON® PulseForge » de la société Xenon Corporation. De manière avantageuse, la distance séparant la lampe du composant **14** est comprise entre 3 centimètres et 7 centimètres, et plus particulièrement 5 centimètres. Cette distance étant la distance à laquelle le système optique de la lampe à Xénon focalise l'impulsion lumineuse envoyée, c'est-à-dire la distance du maximum d'énergie.

L'impulsion UV **52** traverse alors le second composant transparent **14** ainsi que les plages conductrices transparentes **26** et est incidente sur la portion d'oxyde de cuivre **50** comprise dans la couronne de matériau absorbant **28.**

Parallèlement, la couronne de matériau absorbant **28** bloque au moins une partie de l'impulsion ultraviolette et empêche ainsi, au moins partiellement, que cette impulsion atteigne la portion d'oxyde de cuivre formée sur la couronne **28.** L'impulsion ultraviolette **52** induit alors un recuit de l'oxyde de cuivre dans la couronne **28,** qui subit une réduction, formant ainsi les plots de cuivre **30** entre les plages conductrices **18** et **26.** Ainsi l'oxyde de cuivre, qui est mauvais conducteur de l'électricité avec une résistance carré de l'ordre de 10⁶ Ω/□ et un mauvais conducteur thermique avec une faible conductivité thermique égale à 33 W/(m·K), est réduit en cuivre, qui est bon conducteur d'électricité ayant une résistance carré égale à 60 mΩ/□, et un bon conducteur thermique avec une conductivité thermique égale à 403 W/(m·K).

En outre, le recuit est réalisé localement, c'est-à-dire dire au niveau des interconnexions **16,** et non pas sur l'ensemble constitué des composants **12, 14** et des éléments d'interconnexion, mais en outre le recuit induit une température inférieure à 100 °C, et donc une température inférieure à la température de transition vitreuse du PEN

On note par ailleurs que les couronnes de matériau absorbant **28** permettent de définir de manière précise la géométrie des plots de cuivre **30,** et ce même si l'oxyde de cuivre a été déposé par une technique ne permettant pas de contrôler de manière précise ce dépôt.

Les interconnexions **16** décrites précédemment présentent une plage conductrice **26** sur le composant **14,** la plage **26** étant utilisée pour le passage du courant entre les composants **12** et **14.** Par exemple, il existe dans l'épaisseur du composant **14** des connexions électriques en contact avec les plages **26.**

En variante, comme illustré à la figure 15 en vue de dessus et à la figure 16 en coupe selon le plan XII-XII de la figure 15, une piste métallique **54** est réalisée d'un seul tenant avec la couronne **28** conductrice. La piste **54** est notamment réalisée dans le même matériau que la couronne **28** et conjointement avec celle-ci. Cette piste peut ainsi être utilisée pour une connexion électrique avec l'interconnexion **16** sur la face **24** du composant **14.**

Il a été décrit des interconnexions **16** à section carré. Bien entendu, les interconnexions peuvent prendre n'importe quelles formes géométriques, par exemple une forme circulaire comme illustrée à la figure 17 en vue de dessus et à la figure 18 en coupe selon le plan XVIII-XVIII de la figure 17.

Notamment, la forme des interconnexions **16** peut ainsi être dictée par la forme des plages **26** formées sur le second composant **14.** La distance minimale d entre deux interconnexions **16** peut notamment être de l'ordre de 30 micromètres avec une largeur minimale *W_{pad}* égale à 40 micromètres dans le cas de la forme carrée, et un diamètre minimal *D_{PAD}* de 40 micromètres dans le cas d'une forme circulaire. L'épaisseur *W_{abs}* minimale des couronnes **28** est par exemple de 5 micromètres.

De même, il a été décrit des couronnes en matériau absorbant pour bloquer le rayonnement ultraviolet et ainsi empêcher le recuit de l'oxyde de cuivre reposant sur les couronnes. En variante, la couronne est constituée d'un matériau réfléchissant, ce qui bloque également le rayonnement ultraviolet. En variante également, les couronnes sont omises et le composant **14** est revêtu d'une couche réfléchissante ou absorbante ayant des ouvertures au droit des emplacements prévus pour les plots de cuivre **32.** En variante encore, les couronnes **28** sont omises, par exemple si l'application ne nécessite pas une définition précise de la géométrie des plots de cuivre.

Après l'hybridation finale des deux composants et la transformation du CuO en Cu au niveau des connexions, une encre non conductrice électriquement NCP (« *Non Conductive Paste* ») est dispensée, cette étape étant suivie d'un recuit entre 60 et 80 °C pendant quelques minutes afin de solidifier mécaniquement les deux composants hybridés. Par exemple, l'encre est une résine époxy non conductrice électriquement. La dispense est manuelle ou automatique, l'encre pouvant également être déposé par sérigraphie.

Par exemple, l'encre NCP occupe la totalité du volume entre les deux composants. En variante, comme illustré à la vue en coupe de la figure 19, de l'encre NCP **60** est déposée autour des interconnexions **16,** par exemple sous la forme d'un cordon, comme illustré à la figure 20 qui est une vue de dessus du composant **14,** ou de plots.

En variante, l'encre NCP est déposée sur le composant **14** avant le report du composant **12** sur celui-ci, par exemple par sérigraphie, puis le composant **12** est reporté. Un recuit tel que décrit ci-dessous est alors appliqué pour solidifier l'encre.

L'invention présente ainsi les avantages suivants :
▪ la possibilité d'hybrider un composant transparent sur un autre ou un substrat transparent sur un substrat opaque comme le silicium par exemple ;
▪ la géométrie des couronnes bloquant le rayonnement ultraviolet permet d'obtenir un faible pas d'hybridation ;
▪ de bonnes conductivités électriques et thermiques des interconnexions ;
▪ la possibilité d'aligner par la face arrière transparente ;
▪ un faible coût et une flexibilité mécanique, notamment grâce à l'emploi de plastique ;
▪ une passivation directe par l'oxyde de cuivre des parois verticales des plots en cuivre ;
▪ une adaptation des coefficients de dilatation thermique des différentes couches assemblées par l'emploi de l'encre CuO ; et
▪ une rapidité de la fabrication.

## Revendications

1. Procédé de fabrication d'un dispositif microélectronique comportant un premier composant (12) hybridé à un second composant (14) au moyen d'interconnexions électriques (16), comportant :
▪ la réalisation des premier et second composants (12, 14), le second composant (14) étant transparent à un rayonnement ultraviolet au moins au droit d'emplacements prévus pour les interconnexions ;
▪ la formation d'éléments d'interconnexion (22) comprenant des plots constitués uniquement d'oxyde de cuivre (50) sur le second composant (14) aux emplacements prévus pour les interconnexions (16);
▪ le report des premier et second composants (12, 14) l'un sur l'autre ; et
▪ l'application du rayonnement ultraviolet au travers du second composant (14) sur les éléments comprenant de l'oxyde de cuivre de manière à mettre en oeuvre un recuit ultraviolet transformant l'oxyde de cuivre en cuivre.

2. Procédé de fabrication d'un dispositif microélectronique selon la revendication 1, dans lequel la formation des éléments d'interconnexion (22) comprend pour chacun de ceux-ci :
▪ la formation d'une plage (26, 28) sur le second composant (14), la plage (26, 28) comprenant une première région (26) au moins partiellement transparente au rayonnement ultraviolet, entourée d'une seconde région (28) de moindre transparence que la première région (26); et
▪ le dépôt d'oxyde cuivre sur ladite plage (26, 28) au moins sur la première région (26) de celle-ci.

3. Procédé de fabrication d'un dispositif microélectronique selon la revendication 2, dans lequel la seconde région (28) est réalisée en un matériau absorbant le rayonnement ultraviolet ou en un matériau réfléchissant le rayonnement ultraviolet.

4. Procédé de fabrication d'un dispositif microélectronique selon la revendication 2 ou 3, dans lequel la seconde région (28) est constituée d'or, de titane ou d'argent.

5. Procédé de fabrication d'un dispositif microélectronique selon la revendication 4, dans lequel la seconde région (28) a une épaisseur supérieure à 30 nanomètres.

6. Procédé de fabrication d'un dispositif microélectronique selon l'une quelconque des revendications précédentes, dans lequel le second composant (14) est constitué de PEN, de PET ou de verre.

7. Procédé de fabrication d'un dispositif microélectronique selon l'une quelconque des revendications précédentes, dans lequel la formation des interconnexions (16) comporte la réalisation d'une couche d'oxyde métallique transparent (26), notamment d'ITO, sur le second composant (14).

8. Procédé de fabrication d'un dispositif microélectronique selon l'une quelconque des revendications précédentes, dans lequel le recuit ultraviolet consiste en une impulsion photonique d'une durée comprise entre 0,5 milliseconde et 2 millisecondes, et de fluence comprise entre 200 Joules et 1500 Joules, notamment une durée de 1,5 milliseconde et une fluence de 1400 Joules.

9. Procédé de fabrication d'un dispositif microélectronique selon l'une quelconque des revendications précédentes, dans lequel après hybridation des deux composants l'un avec l'autre, on ajoute une encre non conductrice électriquement, et dans lequel on soumet alors la structure finale hybridée à une étape de recuit autour de 60 à 80 °C pendant quelques minutes afin de renforcer mécaniquement les deux composants hybridés.

## Patentansprüche

1. Verfahren zur Herstellung einer mikroelektronischen Vorrichtung, das eine erste Komponente (12) umfasst, die mit einer zweiten Komponente (14) mittels elektrischer Verbindungen (16) hybridisiert ist, bestehend aus:
▪ der Herstellung einer ersten und einer zweiten Komponente (12, 14), wobei die zweite Komponente (14) für ultraviolette Strahlung transparent ist und zwar mindestens an den für die Zwischenverbindungen vorgesehenen Stellen;
▪ der Bildung von Verbindungselementen (22) mit Klötzchen, die ausschließlich aus Kupferoxid (50) bestehen, an der zweiten Komponente (14), an den für die Zwischenverbindungen (16) vorgesehenen Stellen;
▪ Aufeinandersetzen der ersten und der zweiten Komponente (12, 14); und
▪ Anwendung ultravioletter Strahlung durch die zweite Komponente (14) hindurch, auf die Elemente, die aus Kupferoxid bestehen, um einen Ultraviolett-Temperprozess zu durchzuführen, der das Kupferoxid in Kupfer umwandelt.

2. Verfahren zur Herstellung einer mikroelektronischen Vorrichtung gemäß Anspruch 1, bei dem die Bildung von Verbindungselementen (22) für jedes dieser Elemente umfasst:
▪ Bildung eines Bereichs (26, 28) auf der zweiten Komponente (14), wobei der Bereich (26, 28) eine erste Zone (26) umfasst, die zumindest teilweise gegenüber ultravioletter Strahlung durchlässig ist, umgeben von einer zweiten Zone (28), die weniger durchlässig ist als die erste Zone (26); und
▪ Ablagerung von Kupferoxid auf diesem Bereich (26, 28), mindestens in seiner ersten Zone (26).

3. Verfahren zur Herstellung einer mikroelektronischen Vorrichtung gemäß Anspruch 2, bei dem die zweite Zone (28) aus einem Material hergestellt wird, das ultraviolette Strahlung absorbiert oder aus einem Material, das ultraviolette Strahlung reflektiert.

4. Verfahren zur Herstellung einer mikroelektronischen Vorrichtung gemäß Anspruch 2 oder 3, bei dem die zweite Zone (28) aus Gold, Titan oder Silber besteht.

5. Verfahren zur Herstellung einer mikroelektronischen Vorrichtung gemäß Anspruch 4, bei dem die zweite Zone (28) eine Dicke von über 30 Nanometern hat.

6. Verfahren zur Herstellung einer mikroelektronischen Vorrichtung gemäß irgendeinem der vorstehenden Ansprüche, bei dem die zweite Zone (14) aus PEN, PET oder Glas besteht.

7. Verfahren zur Herstellung einer mikroelektronischen Vorrichtung gemäß irgendeinem der vorstehenden Ansprüche, bei dem die Bildung der Zwischenverbindungen (16) die Herstellung einer durchlässigen Metalloxidschicht, insbesondere ITO, auf der zweiten Komponente (14) beinhaltet.

8. Verfahren zur Herstellung einer mikroelektronischen Vorrichtung gemäß irgendeinem der vorstehenden Ansprüche, bei dem das Ultraviolett- Tempern aus einem Photonenimpuls mit einer Dauer zwischen 0,5 Millisekunden und 2 Millisekunden und einer Fluenz zwischen 200 Joule und 1.500 Joule, insbesondere einer Dauer von 1,5 Millisekunden und einer Fluenz von 1.400 Joule besteht.

9. Verfahren zur Herstellung einer mikroelektronischen Vorrichtung gemäß irgendeinem der vorstehenden Ansprüche, bei dem nach der Hybridisierung der beiden Komponenten miteinander, eine elektrisch leitfähige Tinte zugefügt wird, und bei dem dann die hybridisierte Endstruktur einige Minuten lang einem Schritt des Temperns bei 60 bis 80 °C ausgesetzt wird, um mechanisch die beiden hybridisierten Komponenten zu stärken.

## Claims

1. A method of manufacturing a microelectronic device comprising a first component (12) hybridized with a second component (14) by means of electric interconnects (16), comprising:
▪ forming the first and second components (12, 14), the second component (14) being transparent to ultraviolet radiation at least in line with locations provided for the interconnects;
▪ forming interconnection elements (22) comprising pads only made of copper oxide (50) on the second component (14) at the locations provided for the interconnects (16);
▪ placing the first and second components (12, 14) on each other; and
▪ applying the ultraviolet radiation through the second component (14) on the elements comprising copper oxide to implement an ultraviolet anneal converting copper oxide into copper.

2. The microelectronic device manufacturing method of claim 1, wherein the forming of the interconnection elements (22) comprises, for each of these:
▪ forming an area (26, 28) on the second component (14), the area (26, 28) comprising a first region (26) at least partially transparent to ultraviolet radiation surrounded with a second region (28) less transparent than the first region (26); and
▪ depositing copper oxide on said area (26, 28) at least on the first region (26) thereof.

3. The microelectronic device manufacturing method of claim 2, wherein the second region (28) is made of a material absorbing ultraviolet radiation or of a material reflecting ultraviolet radiation.

4. The microelectronic device manufacturing method of claim 2 or 3, wherein the second region (28) is made of gold, titanium, or silver.

5. The microelectronic device manufacturing method of claim 4, wherein the second region (28) has a thickness greater than 30 nanometers.

6. The microelectronic device manufacturing method of any of the foregoing claims, wherein the second component (14) is made of PEN, PET, or glass.

7. The microelectronic device manufacturing method of any of the foregoing claims, wherein the forming of the interconnects (16) comprises forming a layer (26) of transparent metal oxide, particularly ITO, on the second component (14).

8. The microelectronic device manufacturing method of any of the foregoing claims, wherein the ultraviolet anneal is achieved by a photonic pulse having a duration in the range from 0.5 millisecond to 2 milliseconds and having a fluence in the range from 200 Joules to 1,500 Joules, particularly a 1.5-millisecond duration and a 1,400 Joule fluence.

9. The microelectronic device manufacturing method of any of the foregoing claims, wherein after hybridization of the two components with each other, an electrically nonconductive ink is added, and wherein the final hybridized structure is then submitted to a step of annealing around from 60 to 80°C for a few minutes to mechanically strengthen the two hybridized components.
